# FASCICULE DE BREVET EUROPEEN

(11) **EP 0 950 258 B1**
(45) Date de publication et mention de la délivrance du brevet: **17.08.2005**
(21) Numéro de dépôt: 97953964.0
(22) Date de dépôt: 29.12.1997
(51) Int. Cl.: H01L 21/28, C23C 16/04, H01J 37/08

(54) **PROCEDE ET DISPOSITIF DE TRAITEMENT D'UNE SURFACE D'UN SEMI-CONDUCTEUR**
VERFAHREN UND VORRICHTUNG ZUR BEHANDLUNG EINER HALBLEITEROBERFLÄCHE
METHOD AND DEVICE FOR TREATING A SEMICONDUCTOR SURFACE

(30) Priorité: 31.12.1996 FR 9616288
(43) Date de publication de la demande: 20.10.1999
(73) Titulaire: UNIVERSITE PIERRE ET MARIE CURIE, 75252 Paris Cédex 05 (FR)
(72) Inventeur: BRIAND, Jean-Pierre, F-92160 Antony (FR)
(74) Mandataire: Michelet, Alain
(86) Numéro de dépôt international: PCT/FR1997/002441
(87) Numéro de publication internationale: WO 1998/029901

(56) Documents cités:
- EP-A- 0 483 004
- EP-A- 0 567 985
- PATENT ABSTRACTS OF JAPAN vol. 014, no. 380 (E-0965), 16 août 1990 & JP 02 137313 A (RES DEV CORP OF JAPAN;OTHERS: 02), 25 mai 1990,
- BRIAND J -P ET AL: "Decay of hollow atoms above and below a surface" PHYSICAL REVIEW A (ATOMIC, MOLECULAR, AND OPTICAL PHYSICS), NOV. 1996, APS THROUGH AIP, USA, vol. 54, no. 5, ISSN 1050-2947, pages 4136-4139, XP002038014
- PATENT ABSTRACTS OF JAPAN vol. 017, no. 649 (E-1468), 2 décembre 1993 & JP 05 211120 A (SHIMADZU CORP), 20 août 1993,
- J.A. DAGATA ET AL.: "Modification of hydrogen-passivated silicon by a scaning tunneling microscope operating in air" APPLIED PHYSICS LETTERS, vol. 56, no. 20, 14 mai 1990 (1990-05-14), pages 2001-2003, NEW YORK, US

## Description

La présente invention se rapporte au traitement de surface des semi-conducteurs, et concerne un procédé et un dispositif de traitement ainsi qu'un semi-conducteur. Elle a des applications dans le domaine du nettoyage de surfaces, de la gravure et de la réalisation de nano-composants.

On connaît des techniques permettant de préparer des plaquettes de silicium ayant une surface parfaitement passivée et extrêmement plane de silicium hydrogéné, l'hydrogène formant alors une couche monoatomique au-dessus du silicium. Une telle préparation peut être faite à partir d'une plaquette de silicium coupée selon la pratique habituelle de l'homme du métier et exposée à l'air libre. On sait que l'oxygène ambiant recouvre immédiatement les surfaces de la plaquette de manière à oxyder le silicium en formant des molécules de SiO₂ sur typiquement une épaisseur de 5 à 6 couches atomiques correspondant à environ 2nm. Ainsi, selon un procédé habituel aux spécialistes et élaboré par la société BELL TELEPHONE Co., on plonge la plaquette de silicium oxydée en surface dans deux bains successifs, le premier contenant de l'acide fluorhydrique et le second de l'acide fluorhydrique et des ions d'ammonium. On décape ainsi les surfaces traitées et on les recouvre d'une unique couche d'hydrogène. La plaquette obtenue est conservée sous vide pour la protéger de salissures extérieures.

De telles techniques permettent donc d'obtenir des surfaces extrêmement propres, mais ayant une couche extérieure passivée par de l'hydrogène. Or, il s'avère souvent utile de disposer d'une ou plusieurs couches extérieures isolantes, notamment constituée de SiO₂. Par exemple, une plaquette de silicium recouverte d'une couche de SiO₂ peut servir à fabriquer un transistor du type MOS, par dépôt d'une couche supplémentaire métallique.

Un autre problème relatif au traitement de surface de semi-conducteurs concerne la gravure de ces surfaces (lithography). Le marquage des surfaces à l'échelon industriel est actuellement réalisé au niveau d'une fraction de micron, tant du point de vue de la taille de marques que de leur positionnement. Il a été proposé d'envoyer des ions très chargés sur une surface de mica ou de graphite, de façon à créer des défauts ponctuels permanents au moyen de collisions avec contact et hautement énergétiques. Ces défauts forment des boursouflures (blisters) de quelques dizaines de nanomètres, réparties de manière à changer la topographie de la surface.

Des inconvénients majeurs de ce procédé de gravure sont que ces procédés ne font que modifier la topographie de la surface.

Le document EP-A-0.567.985 divulgue un procédé de formation d'un film mince. Ce procédé comprend une première étape d'irradiation sélective d'un substrat dont la surface a été traitée pour contenir des atomes d'hydrogène, de manière à former une zone irradiée et une zone non irradiée sur cette surface. Le procédé comprend une deuxième étape de formation sélective d'un film mince sur la zone non irradiée. D'après l'enseignement de ce document, le procédé divulgué permet de dessiner sur un substrat semi-conducteur des films fins d'aluminium pouvant avoir une épaisseur aussi petite que 100 nm.

Le document Patent Abstract of Japan, vol. 17, N° 649 (E 1468), JP-A-5.211.120 décrit un dispositif permettant de former un échantillon de film mince en ajustant l'énergie cinétique d'un faisceau ionique provenant d'une source liquide d'ions métalliques et envoyé sur une cible. La formation de l'échantillon sur la surface d'un substrat est obtenue par irradiation du substrat au moyen du faisceau ionique.

Le document Applied Physics Letters, vol. 56, N° 20 (14 Mai 1990), pages 2001 à 2003, JA. DAGATA et al., expose la modification chimique de surfaces de silicium passivées avec de l'hydrogène, au moyen d'un microscope à effet tunnel du type STM. Ce document mentionne une résolution de traits de 100 nm.

La présente invention vise un procédé de traitement de surface d'une plaquette de silicium, permettant de rendre cette surface extrêmement propre et plane, et occupée par une ou plusieurs monocouches de SiO₂.

Plus généralement, l'invention vise un procédé de traitement d'une surface d'un semi-conducteur, permettant de rendre cette surface extrêmement propre et bien définie, et occupée par un composé isolant s'étendant sur une ou plusieurs couches moléculaires.

L'invention a aussi pour but un procédé de traitement de surface d'un semi-conducteur, permettant de graver cette surface à une échelle de l'ordre du nanomètre.

L'invention vise de tels procédés qui puissent être faciles à mettre en oeuvre, permettent un contrôle en temps réel de la préparation de surface, et rendent possible un contrôle a posteriori à la fois très simple et extrêmement précis.

Un autre but de l'invention est un dispositif de traitement d'une surface d'un semi-conducteur, permettant un nettoyage de cette surface la rendant extrêmement propre et bien définie, et occupée par un composé isolant sur une ou plusieurs couches moléculaires.

L'invention a également pour objectif un dispositif de traitement d'une surface d'un semi-conducteur permettant la gravure de cette surface à une échelle de l'ordre du nanomètre.

L'invention vise de tels dispositif de traitement qui puissent être simples à réaliser et à mettre en oeuvre, qui permettent un contrôle en temps réel de la préparation de la surface et un contrôle a posteriori de l'état de surface qui soit à la fois simple et extrêmement précis.

L'invention a aussi pour but un semi-conducteur ayant des capacités considérables de stockage d'informations, préférentiellement supérieures d'un facteur au moins égal à 10.000 à celles des semi-conducteurs existants.

A cet effet, l'invention a pour objet un procédé de traitement d'une surface d'un semi-conducteur, cette surface étant occupée par des premières molécules du semi-conducteur ayant des liaisons extérieures, ces liaisons étant saturées par des atomes d'hydrogène.

Dans ce procédé :
- on produit des ions positifs ayant chacun au moins trois charges positives et à basse énergie par rapport au MeV,
- on envoie sous vide un faisceau de ces ions vers au moins une zone de la surface, ces zones couvrant une partie déterminée de la surface,
- on applique au faisceau une tension de décélération à proximité de la surface, de manière à donner aux ions du faisceau une vitesse moyenne commandée, les ions extrayant des électrons des premières molécules de ces zones sans entrer en contact avec la surface, de telle sorte que ces premières molécules perdent leurs atomes d'hydrogène et que les liaisons extérieures correspondantes deviennent pendantes, et
- on envoie sur ces zones un produit saturant les liaisons extérieures pendantes de façon à former des secondes molécules d'un composé isolant.

Par « surface », on entend une partie superficielle du semi-conducteur, généralement coupé approximativement selon un plan cristallographique.

La surface est avantageusement plane, de façon à faire notamment office de substrat pour croissance de couches ou pour gravure. Dans des variantes de réalisation, la surface est courbe.

Par ions positifs « fortement chargés », on entend des ions ayant au moins trois charges positives, et préférentiellement au moins quinze charges positives. Leur énergie est dite « basse » par rapport à celle d'ions obtenus au moyen d'un accélérateur de particules, cette dernière énergie étant de l'ordre du MeV ou du GeV. La faible énergie des ions est ainsi inférieure à quelques dizaines de keV.

Le « vide » sous lequel est envoyé le faisceau d'ions peut correspondre à une pression relativement élevée, par exemple de l'ordre de 10⁻⁹Pa. Il peut aussi être un ultravide.

La tension de décélération est appliquée de façon à pouvoir donner aux ions une énergie très faible, pouvant approcher zéro et généralement inférieure à quelques dizaines d'eV.

Un aspect important du procédé de traitement selon l'invention est que les ions ne rentrent pas en contact avec la surface. Au contraire, ils attirent à eux des électrons de surface, puis repartent en sens opposé.

L'extraction d'électrons d'un semi-conducteur par des ions fortement chargés et à basse énergie est explicitée dans l'article de Jean-Pierre BRIAND présenté à la Quatorzième Conférence Internationale des Applications d'Accélérateurs dans la Recherche et l'industrie, DENTON-Texas, 6-9 Novembre 1996. De manière schématique, un ion fortement chargé et à basse énergie commence à interagir avec le milieu semi-conducteur à une distance relativement importante de la surface, pouvant atteindre plusieurs nanometres. L'ion attire et capture alors des électrons de conduction ou de valence, qui occupent alors les états de Rydberg de l'ion. L'ion devient ainsi un atome creux (hollow atom), c'est-à-dire un atome ayant des couches internes au moins partiellement vide, et des couches externes occupées par des électrons excités. Le nombre d'électrons capturés par l'ion est considérablement plus élevé que sa charge, car une partie de ces électrons sont ensuite expulsés de l'ion par effet Auger. Le nombre d'électrons arrachés au semi-conducteur par un ion est généralement égal à environ trois fois sa charge.

A proximité de la surface, l'ion génère une image électrique qui exerce une force d'attraction sur l'ion et tend ainsi à accélérer son mouvement vers la surface. Cependant, l'extraction d'électrons par l'ion crée sur des semi-conducteurs ou des isolants des trous positifs à la surface, qui compensent cette image électrique. L'atome creux formé à partir de l'ion peut alors être rétrodiffusé (back scattered) sans contact au-dessus de la surface, par « effet trampoline ». L'existence ou non de contact et de pénétration à l'intérieur du matériau semi-conducteur dépend de conditions cinématiques initiales de l'ion: au-dessus d'une vitesse critique, l'ion dirigé vers la surface atteint et pénètre le matériau semi-conducteur en dépit de la formation des trous positifs. En revanche, l'effet trampoline se produit en-deçà de cette vitesse critique. La vitesse critique a une valeur dépendant du potentiel d'extraction du matériau semi-conducteur et de la charge initiale de l'ion positif.

La commande de la vitesse moyenne des ions au moyen de la tension de décélération permet de produire l'effet trampoline et de donner aux ions une charge et une énergie maîtrisées.

De plus, chaque ion extrait des électrons d'une zone élémentaire d'interaction, dont l'étendue est déterminée par la position et la vitesse de l'ion. La zone déterminée vers laquelle est envoyé le faisceau d'ions est ainsi constituée par l'association de l'ensemble des zones élémentaires d'interaction des ions du faisceau.

Les électrons extraits de la surface du semi-conducteur sont essentiellement des électrons participant aux liaisons extérieures des premières molécules. En leur absence, les atomes d'hydrogène saturant les liaisons extérieures se retrouvent réduits à des protons qui ne sont plus liés à la surface. Les liaisons extérieures deviennent ainsi pendantes.

Le décapage de la surface du semi-conducteur peut être parfaitement maîtrisé spatialement, par une position contrôlée du faisceau d'ions permettant de sélectionner précisément les zones de décapage. On effectue préférentiellement le décapage de matière successive, zone après zone, en faisant varier la position ou l'orientation du faisceau ou de la cible. Dans une variante de mise en oeuvre, on dirige simultanément plusieurs faisceaux vers la surface.

Le procédé de traitement de l'invention diffère des techniques de gravure existantes par l'absence de tout contact entre les ions du faisceau et la surface du matériau. Contrairement à la méthode consistant à former des boursouflures par des chocs d'ions, on ne modifie pas la topographie de la surface, mais sa conductivité. En effet, alors que les premières molécules sont semi-conductrices, les secondes molécules sont isolantes.

Dans le domaine de la gravure, le procédé selon l'invention permet ainsi de générer des pointes isolantes de l'ordre du nanomètre. On peut ainsi obtenir une augmentation de stockage d'informations de l'ordre de 100² ou même 1000² par rapport aux techniques existantes. De plus, il est aisé et rapide de contrôler localement la conductivité de la surface après gravure, au moyen d'un microscope à effet tunnel.

Dans le domaine du nettoyage de surface, le procédé de traitement selon l'invention permet d'obtenir une surface extrêmement propre et bien définie occupée par les secondes molécules du composé isolant.

Dans une première forme de mise en oeuvre du procédé de traitement selon l'invention, tes zones recouvrent toute la surface.

Le procédé de traitement revient alors à transformer la surface semi-conductrice en une surface isolante, et est employé préférentiellement dans le cadre d'un nettoyage de surface.

Selon une seconde forme de mise en oeuvre préférée du procédé de traitement selon l'invention, les zones définissent un réseau isolant gravé à la surface du semi-conducteur.

Ce réseau est constitué par les secondes molécules formées, voisinant les premières molécules laissées en place. Cette seconde forme de mise en oeuvre permet d'effectuer la gravure du semi-conducteur.

Préférentiellement (dans les deux formes de mise en oeuvre), après avoir formé le composé isolant dans les zones, on effectue un contrôle local de conductivité électrique au moyen d'un microscope à effet tunnel.

Ce contrôle offre la précision nécessaire au regard de la finesse du traitement. La lecture électrique de la surface peut se faire à l'aide d'une pointe de microscope à effet tunnel balayant cette surface. Ainsi, par « contrôle local », on entend un contrôle localisé à tout instant, mais pouvant s'appliquer par balayage spatial à une partie quelconque de la surface.

Avantageusement, pour préparer préalablement la surface du semi-conducteur à partir d'un état oxydé de la surface:
- on plonge le semi-conducteur dans un premier bain d'acide fluorhydrique, puis
- on plonge le semi-conducteur dans un second bain, d'acide fluorhydrique et d'ions d'ammonium.

Cette étape préalable, qui correspond à la technique élaborée par la société BELL TELEPHONE Co., permet de passer de l'état oxydé de la surface mettant en jeu cinq à six couches atomiques d'oxygène à la surface parfaitement contrôlée avec une seule couche atomique d'atomes d'hydrogène.

Avantageusement, le produit comprend de l'oxygène saturant les liaisons extérieures pendantes.

Les secondes molécules formées ont ainsi des propriétés d'isolation électrique et le semi-conducteur peut servir de substrat pour une croissance contrôlée de couches supplémentaires à partir d'une première couche des secondes molécules, par exemple pour fabriquer un transistor MOS ou un réseau de condensateur par dépôt métallique.

Il est alors intéressant d'envoyer le faisceau d'ions sous vide partiel, de telle sorte qu'on envoie conjointement de l'oxygène saturant les liaisons extérieures pendantes.

De cette manière, il n'est pas nécessaire de prévoir une étape spécifique et indépendante d'envoi du produit, puisque celui-ci est spontanément disponible au voisinage de la surface sous forme d'oxygène. Le vide partiel peut pour se faire être de l'ordre de 10⁻⁹ Pa.

Dans un autre mode de mise en oeuvre de l'envoi du produit, on envoie le faisceau d'ions sous vide très poussé, de façon à éviter que l'oxygène sature les liaisons extérieures pendantes, et on envoie ensuite après décapage de la surface le produit porteur d'atomes saturant les liaisons extérieures pendantes. Ce produit peut être par exemple de l'azote. Les opérations du procédé selon l'invention se déroulent dans un ultravide, par exemple de l'ordre de 10⁻¹⁰ Pa.

Dans un mode de mise en oeuvre préféré du procédé selon l'invention, le semi-conducteur est à base de silicium.

Les premières molécules sont alors essentiellement du SiH. Les secondes molécules sont, quant à elles, du SiO₂ dans le cas où le produit apporte des atomes d'oxygène, et du nitrure de silicium (Si₃N₄) dans le cas où il apporte des atomes d'azote.

Préférentiellement, on contrôle l'extraction des électrons par les ions, en mesurant des rayons X émis lorsque les électrons extraits passent d'une couche électronique à une autre des ions.

En effet, les électrons capturés dans les atomes creux et non expulsés descendent vers des couches plus profondes en provoquant l'émission de rayons X. Ces phénomènes sont décrits dans l'article de Jean-Pierre BRIAND précédemment cité, ainsi que dans un article de Jean-Piere BRIAND et Coll. paru dans Images de la Physique, 1992, pages 58-62. De façon simplifiée, l'émission et la détection de rayons X s'effectue de la manière suivante. Seules les dernières transitions X émises dans les couches profondes sont observées, les transitions dans les couches plus élevées ayant une énergie très faible et étant noyées dans le fond continu. Les transitions mesurées sont donc préférentiellement celles vers les couches L et K. Les lacunes des couches L et K sont remplies pas à pas. Dans le procédé de traitement selon l'invention, les atomes creux sont formés dans des états de Rydberg, de telle sorte qu'un très grand nombre d'étapes est nécessaire pour atteindre les couches profondes. La couche L a alors une vitesse de remplissage faible par rapport à celle de la couche K, de telle sorte qu'un rayon X du type Kα est émis dès qu'un premier électron arrive sur la couche L.

Le remplissage progressif de la couche L, ou plus généralement de couches internes, est avantageusement utilisé pour une mesure temporelle des événements, par détection des rayons X émis. Le remplissage des couches internes génère en effet des marques temporelles espacées de quelques dixièmes de femto-secondes.

Avantageusement, pour le contrôle par mesure de rayons X, on fait varier la tension de décélération et on effectue la mesure de rayons X émis pour plusieurs valeurs de cette tension de décélération.

L'invention a également pour objet un dispositif de traitement d'une surface d'un semi-conducteur, conforme à la revendication 11.

Il permet d'obtenir une surface extrêmement propre et bien définie, recouverte d'une couche isolante ou d'une gravure ayant un motif isolant sur fond semi-conducteur.

Préférentiellement, le dispositif de traitement selon l'invention comprend un microscope à effet tunnel, destiné à effectuer un contrôle local de conductivité électrique de la surface traitée.

De manière préférée, le dispositif de traitement selon l'invention comprend un appareil de mesure de rayons X émis, lors de passages des électrons extraits d'une couche électronique à une autre de ces ions.

L'invention concerne également un semi-conducteur ayant une surface dans laquelle est gravé un réseau isolant. Selon l'invention, le réseau isolant est gravé conformément à l'une des revendications 14 ou 15.

Le procédé selon l'invention donne un moyen d'obtenir un tel nano-composant.

Préférentiellement, la surface après gravure est recouverte d'un revêtement conducteur.

L'invention sera illustrée et mieux comprise à l'aide de modes de mise en oeuvre et de réalisation de l'invention donnés ci-dessous en référence aux dessins annexés, sur lesquels:
La Figure 1A montre une plaquette de semi-conducteur destinée à subir le procédé de traitement de surface selon l'invention.
La Figure 1B montre la plaquette de la Figure 1A après prétraitement.
La Figure 1C montre la plaquette des Figures 1A et 1B après application d'une première forme de mise en oeuvre du procédé de traitement selon l'invention.
La Figure 1D montre la plaquette des Figures 1A et 1B après application d'une seconde forme de mise en oeuvre du procédé de traitement selon l'invention.
La Figure 2 est un schéma synoptique des différentes étapes du prétraitement et du procédé de traitement selon l'invention, permettant de passer de la plaquette de la Figure 1A à celle de la Figure 1C ou 1D, en passant par la plaquette de la Figure 1B.
La Figure 3 est un mode de réalisation schématique du dispositif de traitement selon l'invention.
La Figure 4 représente l'interaction d'un ion positif fortement chargé avec la surface de la plaquette de la Figure 1B, lors de l'application du procédé de traitement selon l'invention.
La Figure 5 illustre des transitions électroniques avec émission de rayons X dans les couches profondes d'un atome creux, lors de l'application à la plaquette de la Figure 1B du procédé de traitement selon l'invention.
La Figure 6 représente un spectre de rayons X mesuré lors de l'application à la plaquette 1B du procédé de traitement selon l'invention, ce spectre étant exprimé en unités de comptage en fonction de l'énergie.

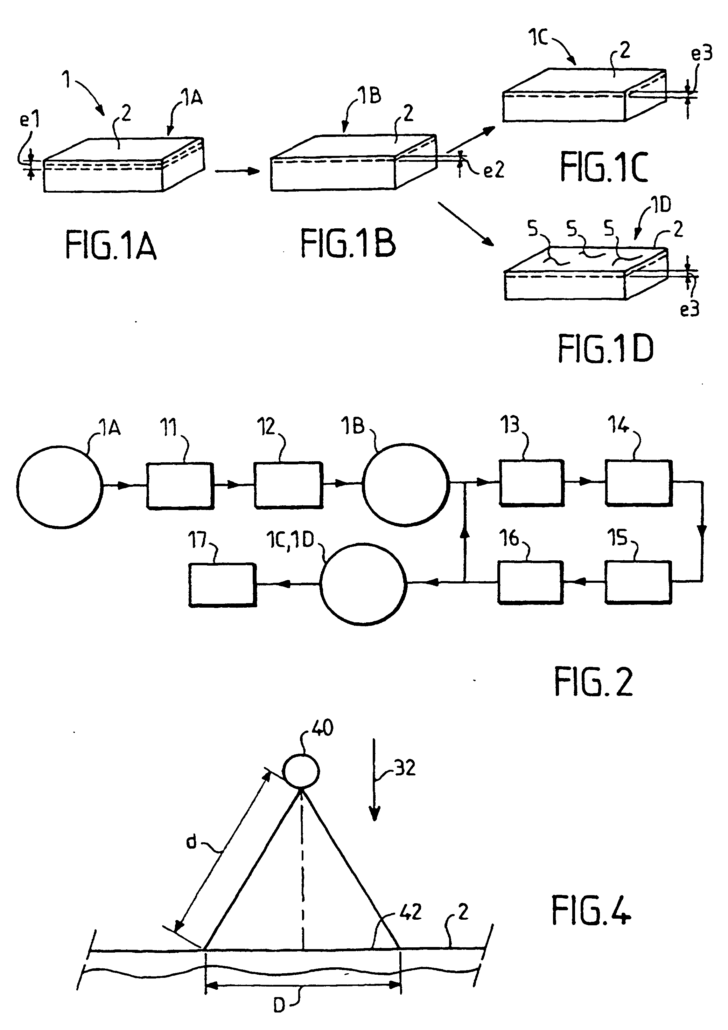

Une plaquette 1 de semi-conducteur, visible sur la Figure 1A, est coupée selon une surface 2. La plaquette 1 est par exemple formée de silicium, exemple avantageux que nous conserverons dans la suite de l'exposé. Le semi-conducteur constituant la plaquette 1 peut être du silicium pur, ou dopé P ou N à diverses concentrations, la concentration de dopage étant avantageusement comprise entre 10¹⁵ et 10¹⁸ atomes implantés par cm³.

La surface 2 a un état oxydé, dû à l'exposition à l'air de la plaquette 1. Le semi-conducteur étant du silicium, des molécules de SiO₂ sont ainsi formées en surface, sur cinq à six couches atomiques. Par « surface », on désigne en réalité une partie superficielle de la plaquette 1 ayant une épaisseur très faible e1, et occupée par les molécules de SiO₂. L'épaisseur e1 vaut approximativement 2 nm.

On applique à la plaquette 1 sous cette forme initiale 1A un prétraitement permettant de décaper la surface 2 et de la recouvrir d'une monocouche d'hydrogène. Ce prétraitement comprend deux étapes 11 et 12, apparaissant sur la Figure 2. Selon la première étape 11 du prétraitement, on plonge la plaquette 1 dans un premier bain, d'acide fluorhydrique, puis dans la seconde étape 12 du prétraitement, on la plonge dans un second bain, d'acide fluorhydrique et comportant des ions d'ammonium. De cette manière, on produit un décapage de la surface 2 qui élimine l'oxygène combiné en surface aux molécules du semi-conducteur de la plaquette 1. On crée ainsi des liaisons extérieures pendantes qu'on sature aussitôt par de l'hydrogène.

Le prétraitement conduit à un état prétraité 1B de la plaquette 1 (Figures 1B et 2), dans lequel la surface 2 est extrêmement bien passivée et plane, et est occupée par des molécules de SiH sur une épaisseur e2. Les atomes d'hydrogène occupent alors une couche atomique unique au-dessus de la plaquette 1.

On soumet ensuite la plaquette 1 a un ensemble d'opérations visant à remplacer tout ou partie des molécules SiH de la surface 2 par des molécules de SiO₂, tout en conservant une excellente définition et une extrême propreté de la surface 2. On distingue deux formes de mise en oeuvre. Dans la première, on remplace l'hydrogène occupant les liaisons extérieures par de l'oxygène sur toute l'étendue de la surface 2. On obtient ainsi un état 1C de la plaquette (Figure 1C), dans lequel les molécules superficielles de SiO₂ couvrent une épaisseur e3 impliquant une seule couche atomique, donc sensiblement inférieure à e1. Le passage de l'état 1A à l'état 1C de la plaquette 1 constitue ainsi un excellent nettoyage de surface, en conservant en l'absence de contact une bonne planéité à l'échelle atomique.

Dans la seconde forme de mise en oeuvre, on remplace de manière sélective les atomes H saturant les liaisons extérieures de la surface 2, en des zones déterminées. On produit ainsi une gravure de la plaquette 1, comme on peut le voir sur la Figure 1D. Pour cette gravure, ces zones déterminées de la surface 2 étant occupées par des pointes isolantes de SiO₂ forment un réseau constitué de parties isolantes 5, les zones complémentaires de la surface 2 restant occupées par des molécules de SiH.

Les opérations de traitement conduisant à la plaquette 1C ou 1D sont similaires et diffèrent essentiellement par l'étendue de la zone traitée. Elles seront donc décrites conjointement pour les deux formes de mise en oeuvre.

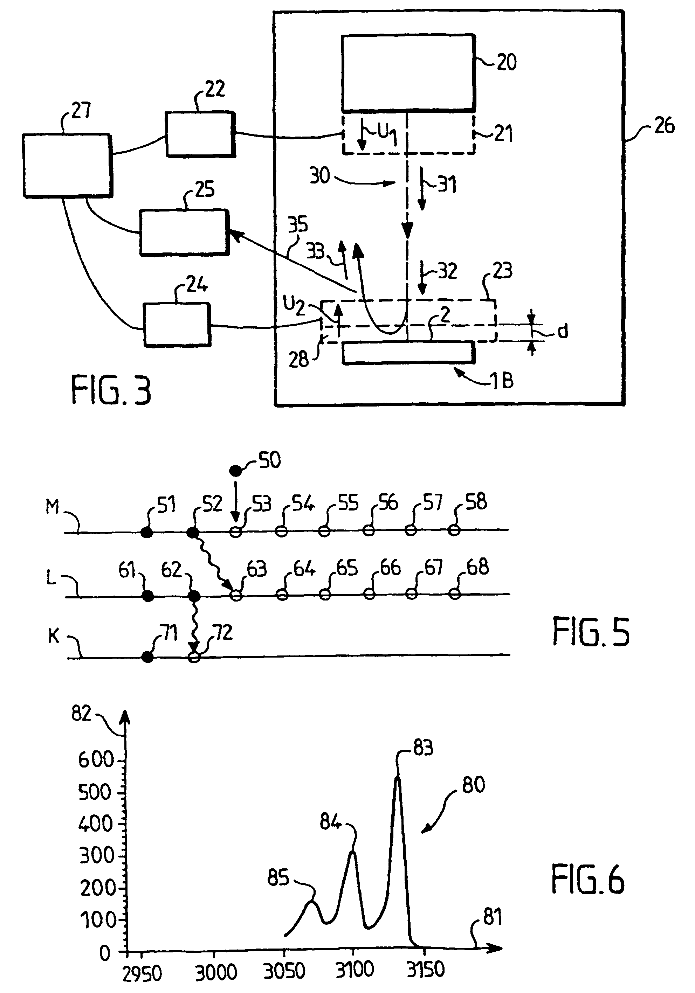

Pour appliquer ces opérations, on a recours à un dispositif de traitement de surface, représenté sur la Figure 3. Ce dispositif comprend une source d'ions 20 produisant des ions positifs fortement chargés et à basse énergie. La source d'ions 20 peut utiliser une préparation des ions à l'intérieur d'un plasma très chaud confiné dans des structures magnétiques, telles qu'une source ECR (Electron Cyclotron Resonance). Elle peut aussi avoir pour principe de fonctionnement la compression de faisceaux d'électrons dans un solénoïde, des atomes injectés dans le faisceau d'électrons étant simultanément ionisées et piégées par charge d'espace. La source d'ions 20 peut ainsi être du type EBIS (Electron Beam Ion Source).

Les ions émis par la source d'ions 20 peuvent être par exemple de l'argon, chargé Ar¹⁷⁺ ou Ar¹⁸⁺, ou de l'uranium. Le nombre de charges positives peut varier de quelques unités à 92 pour l'uranium.

Le dispositif de traitement comprend également des premiers moyens d'application 22 d'une tension d'émission U₁ dans une zone 21 attenante à la source d'ions 20, extrayant des ions de cette source d'ions 20. Les premiers moyens d'application 22 produisent ainsi un faisceau 30 des ions, qu'ils dirigent vers la surface 2 de la plaquette 1 selon une direction 31 contrôlée.

Le dispositif de traitement comprend aussi des seconds moyens d'application 24 d'une tension de décélération U₂ dans une zone 23 au voisinage de la surface 2. Les seconds moyens d'application 24 décélèrent suffisamment les ions du faisceau 30 pour que ceux-ci extraient des électrons de la surface 2 sans contact avec cette surface et soient rétroréfléchis sous forme d'atomes ou ions creux. Les ions émis par la source d'ions 20 ayant une énergie de l'ordre de plusieurs keV/q, par exemple compris entre 5 et 20 keV/q, q désignant le nombre de charges positives de chacun des ions, les seconds moyens d'application 24 donnent aux ions une énergie comprise entre zéro et quelques eV/q de manière contrôlée. Ces seconds moyens d'application 24 peuvent comprendre un condensateur plan avec potentiomètre. Le contrôle de la tension de décélération U₂ permet de maîtriser la distance d'approche de chaque ion par rapport à la surface 2 et donc la taille de la zone élémentaire d'interaction décapée par cet ion.

Les moyens d'application 22 et 24 des tensions U₁ et U₂ permettent d'orienter précisément le faisceau 30 d'ions vers une zone déterminée de la surface 2. Préférentiellement, ils permettent d'assurer la plus grande précision de guidage possible des ions.

Le dispositif de traitement comporte préférentiellement un appareil de mesure 25 de rayon X émis, lors de passages d'électrons extraits de la surface 2 par des ions du faisceau 30, d'une couche électronique à une autre de ces ions.

Le faisceau 30 d'ions émis par la source d'ions 20 et la surface 2 de la plaquette 1 sont préservés de l'air ambiant par une enceinte 26 de mise sous vide.

Le dispositif de traitement comprend aussi, de manière avantageuse, une unité de traitement 27 raccordée à la source d'ions 20, aux moyens d'application 22 et 24 et à l'appareil de mesure 25, permettant de commander et de contrôler l'ensemble des opérations.

Le dispositif de traitement est préférentiellement complété par un microscope à effet tunnel, effectuant un contrôle local de conductivité électrique de la surface 2 traitée.

En fonctionnement, on effectue successivement les opérations suivantes lors du traitement de surface (Figure 2). Dans une première opération 13, on produit des ions positifs fortement chargés à basse énergie au moyen de la source d'ions 20. Dans une deuxième opération 14, on envoie un faisceau 30 des ions vers la surface 2, par les moyens d'application 22 de la tension d'émission U₁. Le faisceau suit alors la direction 31. Dans une troisième opération 15, on applique au faisceau 30 la tension de décélération U₂ à proximité de la surface 2, par les moyens d'application 24. On donne ainsi aux ions du faisceau 30 une vitesse moyenne commandée, dans une direction 32.

Lorsque les ions du faisceau 30 sont suffisamment proches de la surface 2, ils commencent à interagir avec celle-ci. On définit au-dessus de la surface 2, une zone de capture 28, dans laquelle les ions du faisceau 30 peuvent capturer des électrons de la plaquette 1. Cette zone 28 s'étend jusqu'à une distance d au-dessus de la surface 2. Ainsi, dès qu'un ion 40 pénètre dans la zone 28, il interagit avec une portion 42 de cette surface 2 définissant approximativement un disque de diamètre D ayant des contours à une distance d de l'ion 40, comme représenté sur la Figure 4. Le diamètre D de la portion 42 d'interaction ne dépasse donc pas 2d. L'ion 40 attire et extrait ainsi des électrons superficiels de la portion 42 tout au long de son approche dans la zone d'extraction 28. On commande cette approche en ajustant l'énergie cinétique de l'ion 40 grâce aux moyens d'application 24. L'ion 40 capture des électrons qui le transforment en un atome creux.

Cet atome creux est ensuite rétrodiffusée sans contact par effet trampoline. En effet, les trous positifs formés dans la portion 42 de la surface 2 repoussent l'atome creux constitué à partir de l'ion 40, cet atome creux conservant une charge positive. Le faisceau 30 d'ions est ainsi renvoyé en sens opposé à la surface 2 dans un ensemble de directions 33.

Préférentiellement, l'incidence du faisceau 30 sur la surface 2 est normale, le faisceau 30 ayant une position commandée par les moyens d'application 22 et 24.

Au cours de la capture d'électrons par les ions du faisceau 30, on mesure avantageusement au moyen de l'appareil de mesure 25, des rayons X émis lorsque les électrons extraits passent d'une couche électronique à une autre des ions. On contrôle ainsi en temps réel le processus d'extraction des électrons.

A titre d'exemple, la source d'ions 20 est une source ECR produisant des ions Ar¹⁷⁺ ayant une énergie de 11 keV/q. La plaquette 1B est une plaquette de SiH dont la surface 2 est un plan 111 de Si passivé par une monocouche d'hydrogène. La distance d'interaction vaut alors environ 2 nm. On envoie le faisceau 30 des ions vers la surface 2 en incidence normale, et on décélère les ions jusqu'à une gamme d'énergie ajustable comprise entre 0 et 12 eV/q. Lors de l'interaction des ions à une énergie de 1 eV/q avec la surface 2, on observe un spectre 80 de rayons X du type K, tracé sur la Figure 6 selon un axe d'énergie 81 en eV et un axe d'unités de comptage 82. Ce spectre 80 fait apparaître essentiellement trois raies satellites 83-85, qui correspondent respectivement aux satellites KL¹, KL² et KL³. La distribution des raies est fortement piquée sur la raie 83 associée au satellite KL¹.

De manière simplifiée, on peut donner les explications suivantes sur le spectre 80 observé, en référence à la Figure 5. Sur cette Figure 5, des électrons sont représentés par des cercles pleins, et les lacunes par des cercles vides. Les trois couches atomiques les plus internes d'un ion 40, capturant un électron 50, sont appelées K, L et M. La couche K, la plus profonde, comprend schématiquement deux emplacements 71, 72 dont l'un (71) est déjà occupé par un électron et l'autre (72) présente une lacune. La deuxième couche L et la troisième couche M comportent respectivement huit emplacements 61-68 et 51-58, initialement vides dans l'ion 40. Lors de la capture d'électrons par l'ion, une partie de ces électrons descend vers les couches les plus profondes par cascade Auger. L'atome creux ainsi formé étant dans un état de Rydberg, le remplissage de la couche L est lent comparé au remplissage de la lacune 72 de la couche K. Les huit lacunes correspondant respectivement aux emplacements 61-68 de la couche L étant remplies pas à pas, on observe l'émission d'un rayon X correspondant au comblement de l'emplacement 72 de la couche K au début de ce remplissage. On obtient ainsi les raies 83-85 associées à un nombre d'électrons spectateurs sur la couche L compris entre 1 et 3, espacés d'approximativement 25 eV. La couche L étant en moyenne faiblement remplie au moment du comblement de l'emplacement 72 de la couche K, la distribution des raies KL¹..... KL⁸ est concentrée sur les trois premières raies 83-85 et est fortement piquée sur la première raie 83. La mesure précise de l'énergie des raies 83-85 indique de plus le nombre moyen d'électrons sur la couche M, ce nombre étant par exemple voisin de 1 à 2.

De plus, le remplissage de la couche L joue le rôle d'un sablier, un électron Auger principalement étant émis à chaque comblement d'un des espacements 61-68. Par exemple, le remplissage se fait avec une période de 3.10⁻¹⁶s.

L'extraction d'électrons de la surface 2 provoque la disparition à cette surface 2 des atomes d'hydrogène saturant les liaisons extérieures correspondantes. Ces liaisons extérieures deviennent ainsi pendantes.

La position du faisceau 30 et la tension de décélération U₂ définissent une zone d'interaction dans la surface 2, qui est décapée par le faisceau 30. Cette zone s'étend tout au plus dans un périmètre de 2d autour de l'étendue du faisceau 30. De préférence, cette étendue est de l'ordre du nanomètre.

Dans une quatrième opération 16 du traitement de surface, on envoie sur la zone décapée un produit saturant les liaisons extérieures pendantes, de façon à former des molécules d'un composé isolant. Une façon simple de procéder consiste pour cela à appliquer un vide partiel dans l'enceinte 26, de l'ordre de 10⁻⁹ Pa. De l'oxygène présent dans l'enceinte 26 sature alors immédiatement les liaisons pendantes, de manière à former le composé isolant.

On réitère ensuite l'ensemble des opérations 13 à 16, en faisant varier l'orientation et/ou la position du faisceau 30 et/ou de la cible, et éventuellement l'étendue du faisceau 30 et en contrôlant l'énergie des ions de ce faisceau 30 dans la zone d'extraction 28. Dans la première forme de mise en oeuvre du procédé de traitement selon l'invention, on parcourt ainsi l'ensemble de la surface 2 par balayage. On obtient alors l'état 1C de la plaquette 1. Dans la seconde forme de mise en oeuvre du procédé de traitement selon l'invention, en revanche, on ne fait parcourir au faisceau 30, par déplacement de celui-ci ou de la cible, que les zones correspondant aux parties isolantes 5 déterminées. On obtient ainsi l'état 1 D de la plaquette 1.

Dans une variante de mise en oeuvre, on maintient l'intérieur de l'enceinte 26 sous ultravide et on décape l'ensemble des zones prévues dans la surface 2 sans envoyer le produit saturant les liaisons extérieures pendantes. Une fois ce décapage entièrement achevé, on envoie le produit sur l'ensemble de la surface 2 de manière à saturer simultanément les liaisons extérieures pendantes de toutes les zones décapées.

Préférentiellement, on effectue ensuite lors d'une étape supplémentaire 17 un contrôle local de conductivité électrique de la surface 2 de la plaquette 1C ou 1D au moyen d'un microscope à effet tunnel.

Dans la mise en oeuvre exposée jusqu'à présent, on effectuait le prétraitement des étapes 11 et 12 de façon à ce que les atomes d'hydrogène occupent une couche atomique unique au-dessus de la plaquette 1, une partie de ces atomes d'hydrogène étant ensuite remplacée par de l'oxygène, de l'azote, ou tout autre composant approprié au cours des étapes 13 à 16. Dans une variante de cette mise en oeuvre, on envoie le produit saturant les liaisons extérieures pendantes lors de l'opération 16, de manière à former plusieurs couches de ce composant approprié. On produit ainsi des pointes allant de une à plusieurs couches, le nombre de couches étant préférentiellement inférieur à 5. Par exemple, on peut contrôler la pression ou l'injection partielle du produit saturant.

De cette manière, on prend en compte d'éventuelles détériorations superficielles risquant d'entamer une ou plusieurs des couches de la surface 2. La surface 2 obtenue est, comme dans le mode de mise en oeuvre avec une seule couche, extrêmement plane et bien définie.

Ultérieurement, dans un mode de mise en oeuvre avantageux, on recouvre la surface 2 d'un revêtement conducteur. Ce revêtement est préférentiellement métallique, pour la fabrication d'un transistor MOS. Dans ce mode de mise en oeuvre, le dispositif de traitement comprend des moyens de vaporisation sous vide du matériau conducteur dans l'enceinte 26.

## Revendications

1. Procédé de traitement d'une surface (2) d'un semi-conducteur (1B), ladite surface (2) étant occupée par des premières molécules du semi-conducteur ayant des liaisons extérieures, lesdites liaisons étant saturées par des atomes d'hydrogène, dans lequel:
- on produit des ions (40) positifs ayant chacun au moins trois charges positives et à basse énergie par rapport au MeV,
- on envoie sous vide un faisceau (30) desdits ions (40) vers au moins une zone (42) de la surface (2), lesdites zones (42) couvrant une partie déterminée de la surface (2),
- on applique au faisceau (30) une tension de décélération (U₂) à proximité de la surface (2), de manière à donner aux ions (40) du faisceau (30) une vitesse moyenne commandée, lesdits ions (40) extrayant des électrons (50) des premières molécules desdites zones (42) sans entrer en contact avec la surface (2), de telle sorte que lesdites premières molécules perdent leurs atomes d'hydrogène et que les liaisons extérieures correspondantes deviennent pendantes, et
- on envoie sur lesdites zones (42) un produit saturant les liaisons extérieures pendantes de façon à former des secondes molécules d'un composé isolant.

2. Procédé de traitement selon la revendication 1, **caractérisé en ce que** lesdites zones (42) recouvrent toute la surface (2).

3. Procédé de traitement selon la revendication 1, **caractérisé en ce que** lesdites zones (42) définissent un réseau isolant (5) gravé à ladite surface (2) du semi-conducteur (1D),

4. Procédé de traitement selon l'une quelconque des revendications précédentes, **caractérisé en ce qu'**après avoir formé le composé isolant dans lesdites zones (42), on effectue un contrôle local de conductivité électrique au moyen d'un microscope à effet tunnel.

5. Procédé de traitement selon l'une quelconque des revendications précédentes, **caractérisé en ce que** pour préparer préalablement la surface (2) du semi-conducteur (1) à partir d'un état oxydé de la surface (2):
- on plonge le semi-conducteur (1A) dans un premier bain d'acide fluorhydrique, puis
- on plonge le semi-conducteur (1) dans un second bain, d'acide fluorhydrique et comportant des ions d'ammonium.

6. Procédé de traitement selon l'une quelconque des revendications précédentes, **caractérisé en ce que** ledit produit comprend de l'oxygène saturant lesdites liaisons extérieures pendantes.

7. Procédé de traitement selon la revendication 6, **caractérisé en ce qu'**on envoie le faisceau (30) d'ions (40) sous vide partiel, de telle sorte qu'on envoie conjointement de l'oxygène saturant lesdites liaisons extérieures pendantes.

8. Procédé de traitement selon l'une quelconque des revendications précédentes, **caractérisé en ce que** le semi-conducteur (1) est à base de silicium.

9. Procédé de traitement selon l'une quelconque des revendications précédentes, **caractérisé en ce qu'**on contrôle l'extraction des électrons (50) par des ions (40), en mesurant des rayons X émis lorsque les électrons (50) extraits passent d'une couche électronique (K, L, M) à une autre desdits ions (40).

10. Procédé de traitement selon la revendication 9, **caractérisé en ce qu'**on fait varier la tension de décélération (U₂) et on effectue ladite mesure des rayons X émis pour plusieurs valeurs de ladite tension de décélération (U₂).

11. Dispositif de traitement d'une surface (2) d'un semi-conducteur (1B), comprenant:
- une source (20) d'ions (40) positifs,
- des moyens d'application (22) d'une tension d'émission (U₁) extrayant un faisceau (30) desdits ions (40) de la source d'ions (20) et le dirigeant vers la surface (2),
- des moyens d'application (24) d'une tension de décélération (U₂), disposés à proximité de la surface (2) de manière à donner aux ions (40) du faisceau (30) une vitesse moyenne commandée,
- une source d'un produit saturant des liaisons exténeures pendantes à ladite surface (2), ladite source étant destinée à envoyer le produit vers la surface (2) suite à un passage du faisceau (30) rendant pendantes lesdites liaisons extérieures, et
- un dispositif (26) de mise sous vide du faisceau (30) et de la surface (2),
**caractérisé en ce que**:
- la source (20) d'ions (40) est une source d'ions ayant chacun au moins trois charges positives et étant à basse énergie par rapport au MeV, et
- la source de produit est une source d'un produit saturant les liaisons extérieures pendantes de façon à former des molécules d'un composé isolant.

12. Dispositif de traitement selon la revendication 11, **caractérisé en ce qu'**il comprend un microscope à effet tunnel, destiné à effectuer un contrôle local de conductivité électrique de la surface (2) traitée.

13. Dispositif de traitement salon l'une des revendications 11 ou 12, **caractérisé en ce qu'**il comprend un appareil de mesure (25) de rayons X (35) émis, lors de passages des électrons (50) extraits d'une couche électronique (K, L, M) à une autre desdits ions (40).

## Patentansprüche

1. Verfahren zur Behandlung einer Oberfläche (2) eines Halbleiters (1 B), wobei die Oberfläche (2) mit ersten Molekülen des Halbleiters besetzt ist, die außen liegende Bindungen aufweisen, die durch Wasserstoffatome abgesättigt sind, wobei in dem Verfahren:
- positive Ionen (40) erzeugt werden, die jedes wenigstens drei positive Ladungen und eine im Vergleich zu MeV niedrige Energie aufweisen,
- unter Vakuum ein Strahl (30) aus Ionen (40) auf wenigstens eine Zone (42) der Oberfläche (2) geschickt wird, wobei die Zonen (42) einen bestimmten Teil der Oberfläche (2) bedecken,
- auf den Strahl (30) in der Nähe der Oberfläche (2) eine Bremsspannung (U₂) angewendet wird, um den Ionen (40) des Strahls (30) eine Durchschnittsgeschwindigkeit zu verleihen, die erforderlich ist, damit die Ionen (40) den ersten Molekülen der Zonen (42) Elektronen (50) entziehen, ohne mit der Oberfläche (2) in Kontakt zu treten, derart, dass die ersten Moleküle ihre Wasserstoffatome verlieren und die entsprechenden äußeren Bindungen ungesättigt werden, und
- auf die Zonen (42) ein Produkt geschickt wird, das die ungesättigten äußeren Bindungen absättigt, so dass zweite Moleküle einer isolierenden Verbindung gebildet werden.

2. Behandlungsverfahren nach Anspruch 1, **dadurch gekennzeichnet, dass** die Zonen (42) die gesamte Oberfläche (2) bedecken.

3. Behandlungsverfahren nach Anspruch 1, **dadurch gekennzeichnet, dass** die Zonen (42) eine isolierende Struktur (5) definieren, die auf die Oberfläche (2) des Halbleiters (1D) graviert ist.

4. Behandlungsverfahren nach einem der vorhergehenden Ansprüche, **dadurch gekennzeichnet, dass** nach der Ausbildung der isolierenden Verbindung in den Zonen (42) eine lokale Prüfung der elektrischen Leitfähigkeit mit Hilfe eines Rastertunnelmikroskops durchgeführt wird.

5. Behandlungsverfahren nach einem der vorhergehenden Ansprüche, **dadurch gekennzeichnet, dass** zur Vorbehandlung der Oberfläche (2) des Halbleiters (1) ausgehend von einem oxidierten Zustand der Oberfläche (2):
- der Halbleiter (1A) in ein erstes Fluorwasserstoffsäurebad getaucht wird, danach
- der Halbleiter (1) in ein zweites Fluorwasserstoffsäurebad, dass außerdem Ammoniumionen enthält, getaucht wird.

6. Behandlungsverfahren nach einem der vorhergehenden Ansprüche, **dadurch gekennzeichnet, dass** das Produkt Sauerstoff enthält, der die betreffenden ungesättigten äußeren Bindungen absättigt.

7. Behandlungsverfahren nach Anspruch 6, **dadurch gekennzeichnet, dass** unter Teilvakuumbedingungen der Strahl (30) aus Ionen (40) derart geschickt wird, dass Sauerstoff mitgeschickt wird, der die ungesättigten äußeren Bindungen absättigt.

8. Behandlungsverfahren nach einem der vorhergehenden Ansprüche, **dadurch gekennzeichnet, dass** der Halbleiter (1) auf Silicium basiert.

9. Behandlungsverfahren nach einem der vorhergehenden Ansprüche, **dadurch gekennzeichnet, dass** das Entziehen von Elektronen (50) durch die Ionen (40) überwacht wird, indem die Röntgenstrahlung gemessen wird, die ausgesendet wird, wenn die entzogenen Elektronen (50) von einer Elektronenschale (K, L, M) zu einer anderen der Ionen (40) übergehen.

10. Behandlungsverfahren nach Anspruch 9, **dadurch gekennzeichnet, dass** die Bremsspannung (U₂) variiert wird und die Messung der ausgesendeten Röntgenstrahlung für mehrere Werte der Bremsspannung (U₂) durchgeführt wird.

11. Vorrichtung zur Behandlung einer Oberfläche (2) eines Halbleiters (1B), umfassend:
- eine Quelle (20), die positive Ionen (40) abgibt,
- Mittel (22) zum Anlegen einer Emissionsspannung (U₁), die einen Strahl (30) aus den Ionen (40) aus der Ionenquelle (20) freisetzt und ihn in Richtung der Oberfläche (2) lenkt,
- Mittel (24) zum Anlegen einer Bremsspannung (U₂), die in der Nähe der Oberfläche (2) angeordnet sind, um den Ionen (40) des Strahls (30) eine erforderliche Durchschnittsgeschwindigkeit zu verleihen,
- eine Quelle, die ein Produkt abgibt, das die ungesättigten äußeren Bindungen der Oberfläche (2) absättigt, wobei die Quelle dafür bestimmt ist, das Produkt unmittelbar nach einem Durchgang des Strahls (30), der die äußeren Bindungen ungesättigt werden lässt, auf die Oberfläche (2) zu schicken, und
- eine Vorrichtung (26), die den Strahl (30) und die Oberfläche (2) unter Vakuum setzt,
**dadurch gekennzeichnet dass**:
- die lonenquelle (20) eine Quelle (20) von Ionen (40) ist, die jeweils wenigstens drei positive Ladungen aufweisen und auf einer im Vergleich zu MeV niedrigen Energie sind, und
- die Produktquelle eine Quelle eines Produkts ist, das die ungesättigten äußeren Bindungen in der Weise absättigt, dass Moleküle einer isolierenden Verbindung gebildet werden.

12. Behandlungsvorrichtung nach Anspruch 11, **dadurch gekennzeichnet, dass** sie ein Rastertunnelmikroskop umfasst, das dafür bestimmt ist, eine lokale Prüfung der elektrischen Leitfähigkeit der behandelten Oberfläche (2) durchzuführen.

13. Behandlungsvorrichtung nach Anspruch 11 oder 12, **dadurch gekennzeichnet, dass** sie ein Gerät (25) zur Messung der Röntgenstrahlung (35), die ausgesendet wird, wenn die entzogenen Elektronen (50) von einer Elektronenschale (K, L, M) zu einer anderen des Ions (40) übergehen, umfasst.

## Claims

1. A method for treating a surface (2) of a semiconductor (1B), whereby this surface (2) is made by first molecules of the semiconductor with external bonds and the said bonds are saturated with hydrogen atoms, **characterised in that** the method comprises the step of:
- generating positive ions (40) each having at least three positive charges and with low energy with respect to the MeV,
- sending under vacuum a beam (30) of these ions (40) toward at least one zone (42) of the surface (2), whereas the said zones (42) cover a determined portion of the surface (2),
- applying to the beam (30) a deceleration voltage (U₂) close to the surface (2), in order to give the ions (40) of the beam (30) a controlled average speed, whereas the said ions (40) extract electrons (50) of the first molecules of the said zones (42) without contacting the surface (2), so that the said first molecules lose their hydrogen atoms and that the corresponding external bonds become pendant, and
- sending toward the said zones (42) a product saturating the pendant external bonds in order to form second molecules of an insulating compound.

2. A treatment method according to claim 1, **characterized in that** the said zones (42) cover the whole surface (2).

3. A treatment method according to claim 1, **characterized in that** the said zones (42) delineate an insulating network (5) etched at the said surface (2) of the semiconductor (1D).

4. A treatment method according to any one of the previous claims, **characterized in that** after having formed the insulating compound in the said zones (42), local electrical conductivity control is carried out using a tunnel effect microscope.

5. A treatment method according to any one of the previous claims, **characterized in that**, in order to previously prepare the surface (2) of the semiconductor (1) from an oxidised condition of the surface (2), the method comprises the step of:
- dipping the semiconductor (1A) into a first hydrofluoric acid bath, then
- dipping the semiconductor (1) into a second bath, of hydrofluoric acid and comprising ammonium ions.

6. A treatment method according to any one of the previous claims, **characterized in that** the said product comprises oxygen saturating the said pendant external bonds.

7. A treatment method according to claim 6, **characterized in that** the beam (30) of ions (40) is sent under partial vacuum, so that oxygen saturating the said pendant external bonds is sent jointly.

8. A treatment method according to any one of previous claims, **characterized in that** the semiconductor (1) is based on silicon.

9. A treatment method according to any one of the previous claims, **characterized in that** extraction of the electrons (50) by ions (40) is controlled by measuring emitted X-rays when extracted electrons (50) switch from one electronic layer (K, L, M) to another layer of the said ions (40).

10. A treatment method according to claim 9, **characterized in that** the deceleration voltage (U₂) is caused to vary and the said emitted X-rays are measured for several values of the said deceleration voltage (U₂).

11. A device for treating a surface (2) of a semiconductor (1 B), comprising:
- a source (20) of positive ions (40),
- means for applying (22) an emission voltage (U₁) extracting a beam (30) of the said ions (40) of the ion source (20) and directing the said toward the surface (2),
- means for applying (24) a deceleration voltage (U₂), arranged close to the surface (2) in order to give the ions (40) of the beam (30) a controlled average speed,
- a source of a product saturating the pendant external bonds on said surface (2), said source being provided to send the product toward the surface (2) further to a passage of the beam (30) making pendant external bonds, and
- a device (26) for depressurising the beam (30) and the surface (2),
**characterized in that** :
- the source (20) of ions (40) is an ion source having each at least three positives charges and with low energy with respect to the MeV, and
- the source of product is the source of a product saturating the pendant external bonds in order to form molecules of an insulating compound.

12. A treatment method according to claim 11, **characterized in that** it comprises a tunnel effect microscope, performing local electrical conductivity control of the treated surface (2).

13. A treatment method according to any one of claims 11 or 12, **characterized in that** it comprises an instrument (25) for measuring emitted X-rays (35) emitted when the electrons (50) extracted from an electronic layer (K, L, M) switch to another layer of the said ions (40).
